# EUROPEAN PATENT SPECIFICATION

(11) **EP 3 621 419 B1**
(45) Date of publication and mention of the grant of the patent: **24.08.2022**
(21) Application number: 19195463.5
(22) Date of filing: 04.09.2019
(51) Int. Cl.: H01M 50/20, H01M 50/247, H01M 50/576, H05K 5/00, H05K 5/02, H01M 50/213

(54) **THERMOSTAT COMPRISING A MOVEABLE COVER**
THERMOSTAT MIT BEWEGLICHER ABDECKUNG
THERMOSTAT COMPRENANT UN COUVERCLE AMOVIBLE

(30) Priority: 05.09.2018 GB 201814428
(43) Date of publication of application: 11.03.2020
(73) Proprietor: Ademco Inc., Golden Valley, MN 55422 (US)
(72) Inventor: KYNOCH, David, Barnsley, South Yorkshire S755GS (GB); ADAMS, Gary, Coatbridge, North Lanarkshire, ML5 5SR (GB); GKANIDIS, Efstathios, Golden Valley, MN Minnesota 55422 (US)
(74) Representative: Murgitroyd & Company

(56) References cited:
- FR-A1- 2 795 850
- US-B1- 7 438 469
- US-B1- 7 569 777

## Description

### Field of the Invention

The present invention concerns thermostats. More particularly, but not exclusively, this invention concerns a thermostat with a securable cover.

### Background of the Invention

Thermostats typically provide a user interface by which a user may adjust settings (e.g. the temperature set-point). The thermostat may then control an associated HVAC apparatus accordingly. Many thermostats are battery powered to power an electronic display and enable wireless communication with the HVAC apparatus. Sometimes, thermostats may comprise a moveable cover element that covers some control buttons, whilst still permitting viewing of the display screen.

In some applications, such as in social housing, student accommodation or commercial property, it has been found that batteries in the thermostat are sometimes removed from the thermostat by a third party. This may happen, for example, due to the thermostat having the same (e.g. AA) batteries that an occupant requires for other uses. Removal of the batteries is undesirable as it may prevent the thermostat from operating. Notwithstanding the above-mentioned problem, it is necessary to still make the battery compartment accessible in the event of a genuine need to replace the battery.

US7438469B1 discloses a thermostat with a cover that, when closed, covers the battery compartment and the control buttons. FR2795850A1 discloses a security detector with means for preventing access to the inside components. US7569777B1 discloses a thermostat with a key-locking feature for preventing access to the thermostat controls.

The present invention seeks to mitigate the above-mentioned problems. Alternatively or additionally, the present invention seeks to provide an improved thermostat.

### Summary of the Invention

The present invention provides, according to a first aspect, a thermostat comprising a main body and a cover, the main body comprising a display screen, a control button, and a battery compartment for housing a battery to power the thermostat. The cover is moveable between an open configuration in which the battery compartment and control button are accessible, and a closed configuration in which the cover shields the battery compartment and control button. The thermostat further comprises a finger protruding from one of the cover or main body; a slot in the other of the cover or main body, for receiving the finger when the cover is in the closed configuration. A first bore extending through the cover or main body and a second bore extending through the finger are also provided, the first and second bores being aligned when the cover is in the closed configuration. A fastener, received in the first bore, for inserting into the second bore when the cover is in the closed configuration is also provided, thereby preventing removal of the finger from the slot such that the cover is locked in the closed configuration. The finger, the slot, the first bore, the second bore and the fastener form a locking arrangement for locking the cover in the closed configuration.

Providing a thermostat with a cover that can be locked in the closed configuration has been found to be advantageous because it prevents easy access to the battery compartment (and hence easy removal of the battery). Furthermore, an arrangement in which the thermostat comprises the first and second bores that align when the cover is closed, has been found to be especially beneficial because it more readily enables the fastener to be concealed from view. This may make it less clear to a third party *how* the cover would be removed, and therefore also reduces the likelihood of the cover being unlocked to access the battery compartment.

The display screen is preferably visible in both the open and closed configurations of the cover.

The fastener may have a shank and a fastener head. The fastener head may be recessed within the first bore when the cover is locked in the closed configuration.

The fastener head being recessed within the first bore may provide an additional barrier against someone seeking to open the cover as it reduces the visibility of the screw head. Alternatively or additionally, it may make it more onerous for third parties to determine the correct tool to use on the fastener because it is more challenging to see the fastener head.

The fastener of the thermostat may be a screw. The screw may comprise a threaded shank. The screw may comprise a screw head.

The screw head is preferably of a type not commonly found in a household. Advantageously, by providing such a screw head, it becomes more difficult for third parties to unlock the cover.

The screw head is preferably *not* in the form of a slotted, Phillips and/or a Pozidriv screw head. The screw head may be in the form of a lesser-used screw head, for example a star-shaped head. In some embodiments of the invention, the screw head may be in the form of a star-shaped head, such as a Torx^{™} head. In embodiments of the invention, the screw head may be in the form of a Hex drive, Hex Socket Drive or One Way Drive. Some of the screwdrivers for these screw heads are commercially available, but not commonly available to third parties.

The screw head may be of a type that is only available to specified parties (for example licenced engineers).

The cover is moveable between the open and closed configurations. The cover may be pivotally connected to the main body via a hinge. Having a hinged cover has been found to be advantageous when used in combination with the locking arrangement of the invention because it tends to ensure the fingers are consistently located correctly within the slot. The fingers may be positioned at the opposite end of the cover to the hinge. The hinge is preferably located along the upper edge of the thermostat.

In the closed configuration, the cover shields the control button. The control button may be a first control button and the thermostat may comprise a second control button. The second control button may remain accessible when the cover is both open and closed. A first set of functions may be controlled by the first control button (i.e. the control button that is shielded by the closed cover). A second set of functions of the thermostat may be controlled by the second control button. In an example embodiment, the second control button is part of a set of externally visible buttons that may control some basic function of the thermostat, such as the temperature set point for the HVAC apparatus. The first control button (which may be part of a first set of buttons) may retain some more advanced control (for example programming of the thermostat). Advantageously, this allows for only a restricted amount of functional control to be granted to third parties.

The thermostat may comprise a front face. The thermostat may comprise a rear face. The thermostat may comprise side faces extending between the front and rear faces. The front face may have a greater area than the rear face. The side faces may taper from the front face towards the rear face. The side faces may have a convex profile. The side faces may extend around corners. The corners may be curved. The first bore may extend into the main body from one of the corners, preferably a lower corner. The longitudinal axis of the first bore may be located at an angle to the vertical and horizontal (i.e. height and lateral dimensions of the thermostat). Providing the first bore on a lower corner, and at an angle to the vertical and horizontal has been found to ensure the bore is relatively unobtrusive and therefore not readily visible to third parties.

The thermostat may comprise two fingers and two corresponding slots. The fingers and slots may be located on the lower corners of the thermostat.

In some commercial scenarios (for example when selling into a purely domestic environment) it may be desirable to provide the thermostat of the first aspect but without necessarily needing the cover to be securable. If the fastener is not in place, the cover may be unsecured, allowing for easy opening and closing. In this case, there may be provided a blank, for insertion into the first bore, otherwise occupied by the fastener screw. This may enable improved aesthetics when the screw is not in place. The blank may be flush with the surface of the main body or cover.

### Description of the Drawings

Embodiments of the present invention will now be described by way of example only with reference to the accompanying schematic drawings of which:
FIG 1 shows frontal view of a thermostat according to a first embodiment of the invention;
FIG 2 shows an upper perspective view of a thermostat of FIG 1;
FIG 3 shows a lower perspective view of the thermostat of FIG 1;
FIG 4 shows a perspective view of the thermostat of FIG 1 with the cover in its open configuration; and
FIG 5 shows a front view of the thermostat of FIG 4.

### Detailed Description

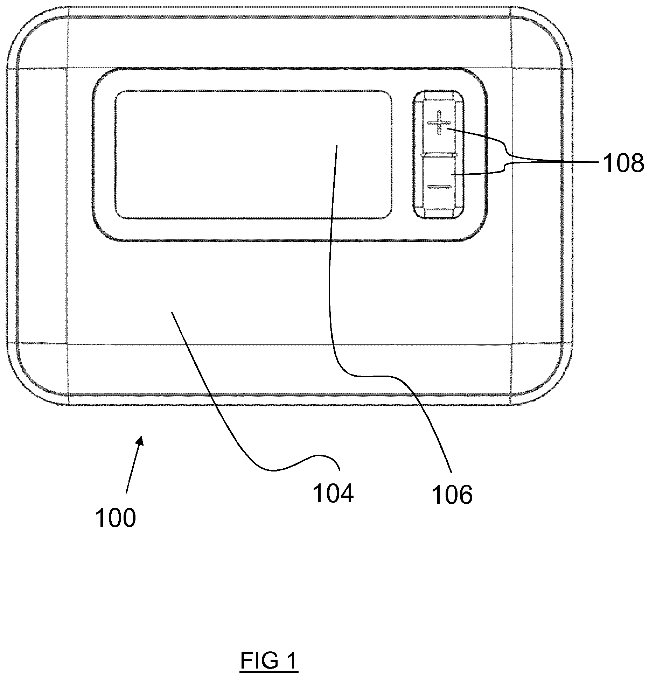

FIG 1 shows the front view of a thermostat 100 according to a first embodiment of the invention. The thermostat 100 comprises a display 106, an externally-visible set of buttons 108 and a cover 104, the cover 104 covering a portion of the thermostat 100. In FIG 1 the cover 104 is shown in its closed position.

When the cover 104 of the thermostat is in its closed position, the functionality of the thermostat 100 may be controlled only by the externally-visible set of buttons 108. The buttons 108 may not fully control the thermostat, but may give basic control over a main function, for example they may allow anyone control of the temperature set-point within a given range.

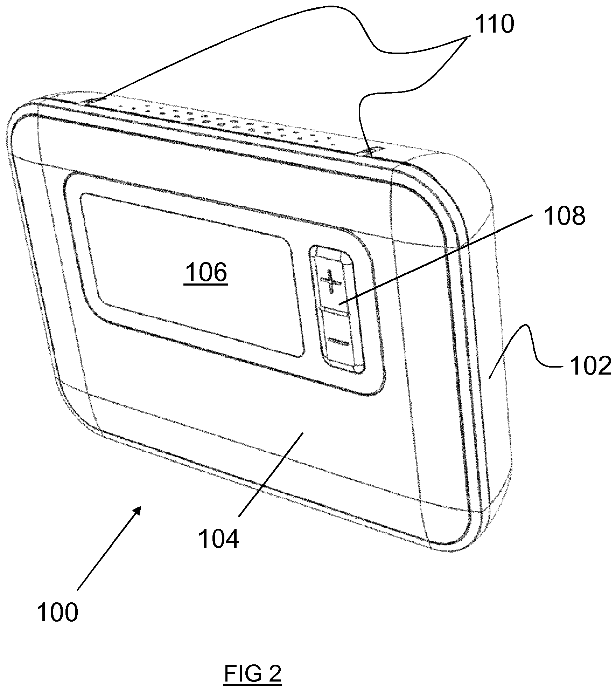

Referring to FIG 2, the thermostat 100 further comprises a main body 102, on which are disposed the display 106 and the buttons 108. A hinge 110 along the upper edge of the thermostat 100 connects the cover 104 to the main body 102. The hinge 110 is arranged on the top surface of the thermostat 100 so that when the cover 104 is closed, the hinge sits flush with the main body 102.

As is noticeable from FIG 1 and FIG 2, when viewed from the front and/or above there is no immediately obvious way for third parties to open the cover 104, or any indication of what lies thereunder.

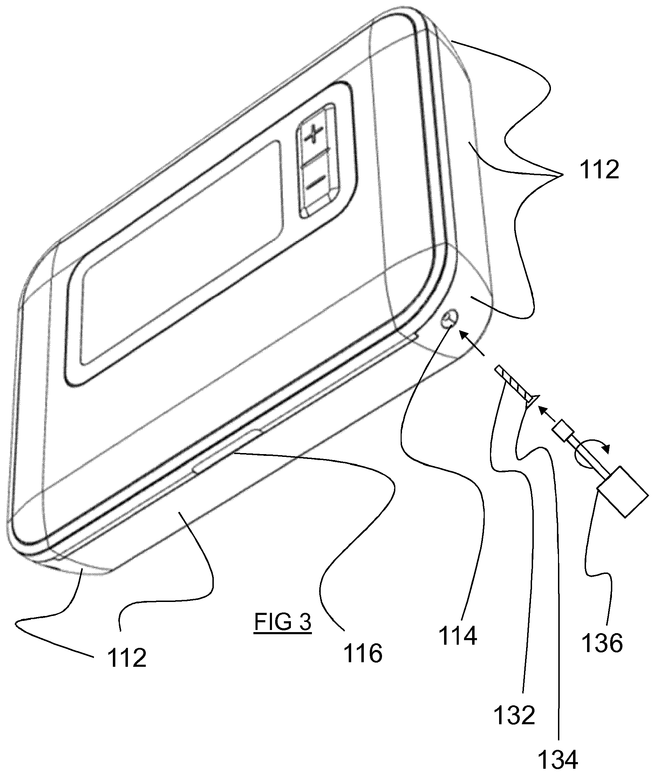

Referring to FIG 3, the main body 102 of the thermostat 100 comprises a convex profiled edge surface 112 extending from the front face to the rear face. On the lower-most corners of that edge surface 112, there is located a first bore 114 extending from the outer surface of the main body into the thermostat (described in more detail below). The profiled edge surface 112 is profiled such that, when the thermostat 100 is viewed from above and/or from the front, the first bore 114 is fully/partially concealed from view. By positioning the bore 114 on the corner of the thermostat, the bore 114 tends to also be either not visible or is only partially visible from most conventional view points (e.g. the front, or slightly from above).

FIG 3 schematically shows a fastener in the form of a screw 132 being inserted into the bore 114 by a screwdriver 136. The screw 132 comprises a screw head 134 and a threaded shank. The use of the screw 132 to lock the cover 104 in a closed position is described in more detail below. Another screw would also be inserted into a bore on the laterally adjacent lower corner but for the sake of clarity, only one of those screws/bores is described below.

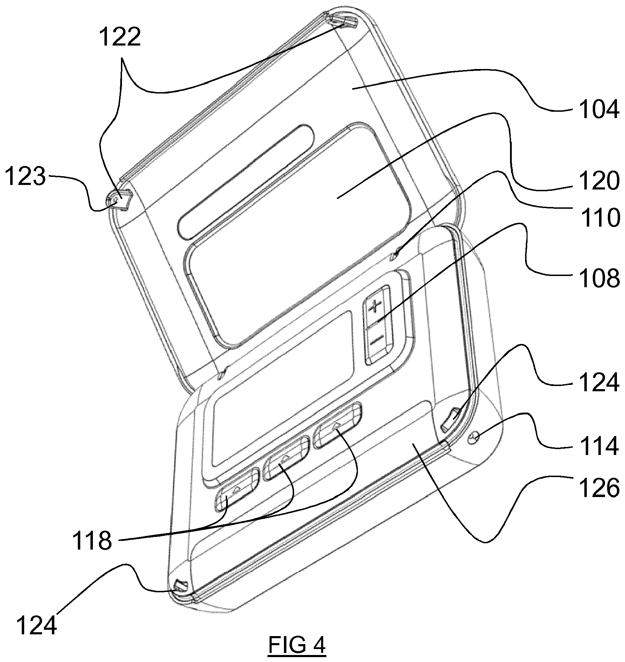

FIG 4 shows the thermostat 100 with the cover 104 in the open configuration. As can be seen from FIG4, a set of buttons 118 and a battery compartment cover 126 are then visible.

The underside of the cover 104 comprises a pair of fingers 122 protruding from the inside corners of the cover 104 and extending perpendicularly therefrom. Each of the fingers comprise a bore 123.

The main body of the thermostat comprises two slots 124 located for receiving the fingers 122 when the cover is closed. The first bore 114 extends from the outer surface of the main body into the slot 124. Furthermore, when the cover is closed, the bore 123 on each finger is arranged so that it is aligned (i.e. co axial) with the first bore 114.

A window 120 in the cover 104 allows the display 106 and the externally-visible button 108 to be visible and interacted with when the cover 104 is closed, but as can be seen by comparing Figures 4-5 with Figures 1-3, the cover 104 shields the set of buttons 118 and access to the battery compartment 126.

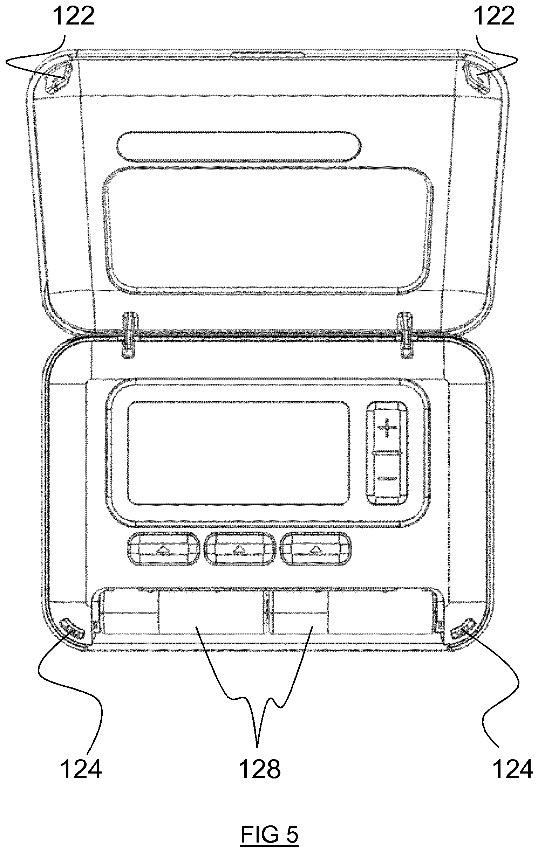

FIG 5 shows the thermostat 100 without the battery cover 126, so that the batteries 128 are visible. When the cover 104 is open, the battery cover 126 can be removed easily. The batteries 128 are only accessible when the cover 104 is open and the battery cover 126 is removed.

Referring back now to FIG3, the screw 132 may be used to secure the cover 104 in its closed position. When the cover is closed, the screw 132 is inserted into the first bore 114 of the main body 102, through the second bore 123 of the finger 122, and screwed into a thread thereafter. This secures the cover 104 in place such that third parties cannot open the cover without removing the screw 132.

The screw head 134 of the screw 132 is recessed into the first bore, such that the screw head 134 is not visible when the thermostat is viewed from above and/or the front. Furthermore the screw-head is a star-shaped screw head and is therefore not designed to receive conventional tools such as slotted, Phillips or Posidrive screwdrivers.

The above-mentioned combination of features has been found to be especially beneficial because it provides a series of barriers to third parties opening the cover: firstly, the bore and screw are not readily visible; secondly, even if they are viewed, the relatively unusual screw head will make it difficult for many third parties to unscrew the fastener without bespoke tools. This is expected to reduce the likelihood of the cover being unlocked and therefore the likelihood of the batteries being removed by unauthorised parties. Nevertheless, authorised parties with the correct tools and knowledge of the thermostat can still readily access the batteries should they genuinely need replacement (for example if they have run flat).

Whilst the present invention has been described and illustrated with reference to particular embodiments, it will be appreciated by those of ordinary skill in the art that the invention lends itself to many different variations not specifically illustrated herein. as long as they fall within the scope of the appended claims.

Where in the foregoing description, integers or elements are mentioned which have known, obvious or foreseeable equivalents, then such equivalents are herein incorporated as if individually set forth. Reference should be made to the claims for determining the true scope of the present invention, which should be construed so as to encompass any such equivalents.

## Claims

1. A thermostat (100) comprising a main body (102) and a cover (104), the main body comprising a display screen (106), a control button (118), and a battery compartment (126) for housing a battery (128) to power the thermostat,
wherein the cover is moveable between an open configuration in which the battery compartment and control button are accessible, and a closed configuration in which the cover shields the battery compartment and control button, **characterized in that** the thermostat further comprises:
a finger (122) protruding from one of the cover or main body;
a slot (124) in the other of the cover or main body, for receiving the finger when the cover is in the closed configuration;
a first bore (114) extending through the cover or main body, and a second bore (123) extending through the finger, the first and second bores being aligned when the cover is in the closed configuration;
and a fastener (132) receivable in the first bore, for inserting into the second bore when the cover is in the closed configuration, thereby preventing removal of the finger from the slot such that the cover is locked in the closed configuration, wherein the finger, the slot, the first bore, the second bore and the fastener form a locking arrangement for locking the cover in the closed configuration.

2. The thermostat (100) of claim 1, wherein the fastener comprises a fastener head, and the fastener head is recessed within the first bore (114) when the cover (104) is locked in the closed configuration.

3. The thermostat (100) of claim 1 or claim 2, wherein the fastener is a screw comprising a threaded shank and a screw head (134).

4. The thermostat (100) of claim 3, wherein the screw head (134) is not in the form of a slotted, Phillips or Pozidriv screw head.

5. The thermostat (100) of claim 3, wherein the screw head (134) is in the form of a star-shaped head.

6. The thermostat (100) of claim 1, further comprising a blank receivable in the first bore (114) when the fastener is not received in the first bore, thereby blanking off the entrance to the first bore.

7. The thermostat (100) of any preceding claim, wherein the cover (104) is pivotally connected to the main body (102) via a hinge (110).

8. The thermostat (100) according to claim 7, wherein the finger (122) is positioned at the opposite end of the cover to the hinge (110).

9. The thermostat (100) according to any preceding claim, wherein the control button is a first control button (118), and the thermostat comprises a second control button (108), the second control button being accessible when the cover (104) is in the closed configuration.

10. The thermostat (100) according to claim 9, wherein a first set of functions is controlled by the first control button (118), and a second set of functions of the thermostat is controlled by the second control button (108).

11. The thermostat (100) according to claim 9 or claim 10, wherein the second control button (108) controls the temperature set point.

## Patentansprüche

1. Ein Thermostat (100), der einen Hauptkörper (102) und eine Abdeckung (104) beinhaltet, wobei der Hauptkörper einen Bildschirm (106), einen Bedienungsknopf (118) und ein Batteriefach (126) zum Unterbringen einer Batterie (128), um den Thermostat mit Energie zu versorgen, beinhaltet,
wobei die Abdeckung zwischen einer offenen Konfiguration, in der das Batteriefach und der Bedienungsknopf zugänglich sind, und einer geschlossenen Konfiguration, in der die Abdeckung das Batteriefach und den Bedienungsknopf abschirmt, bewegbar ist, **dadurch gekennzeichnet, dass** der Thermostat ferner Folgendes beinhaltet:
einen Stift (122), der von einem von der Abdeckung oder dem Hauptkörper vorsteht;
eine Aussparung (124) in dem anderen von der Abdeckung oder dem Hauptkörper zum Aufnehmen des Stifts, wenn sich die Abdeckung in der geschlossenen Konfiguration befindet;
eine erste Bohrung (114), die sich durch die Abdeckung oder den Hauptkörper erstreckt, und eine zweite Bohrung (123), die sich durch den Stift erstreckt, wobei die erste und die zweite Bohrung aufeinander abgestimmt sind, wenn sich die Abdeckung in der geschlossenen Konfiguration befindet;
und ein Befestigungselement (132), das in der ersten Bohrung aufgenommen werden kann, zum Einführen in die zweite Bohrung, wenn sich die Abdeckung in der geschlossenen Konfiguration befindet, wodurch die Entfernung des Stifts aus der Aussparung verhindert wird, so dass die Abdeckung in der geschlossenen Konfiguration gesichert ist, wobei der Stift, die Aussparung, die erste Bohrung, die zweite Bohrung und das Befestigungselement eine Sicherungsanordnung zum Sichern der Abdeckung in der geschlossenen Konfiguration bilden.

2. Thermostat (100) gemäß Anspruch 1, wobei das Befestigungselement einen Befestigungselementkopf beinhaltet und der Befestigungselementkopf in der ersten Bohrung (114) versenkt ist, wenn die Abdeckung (104) in der geschlossenen Konfiguration gesichert ist.

3. Thermostat (100) gemäß Anspruch 1 oder Anspruch 2, wobei das Befestigungselement eine Schraube ist, die einen Gewindeschaft und einen Schraubenkopf (134) beinhaltet.

4. Thermostat (100) gemäß Anspruch 3, wobei der Schraubenkopf (134) nicht in der Form eines Schlitz-, Phillips- oder Pozidriv-Schraubenkopfs vorliegt.

5. Thermostat (100) gemäß Anspruch 3, wobei der Schraubenkopf (134) in der Form eines sternförmigen Kopfs vorliegt.

6. Thermostat (100) gemäß Anspruch 1, der ferner einen Platzhalter beinhaltet, der in der ersten Bohrung (114) aufgenommen werden kann, wenn das Befestigungselement nicht in der ersten Bohrung aufgenommen ist, wodurch der Eingang zu der ersten Bohrung verschlossen wird.

7. Thermostat (100) gemäß einem der vorhergehenden Ansprüche, wobei die Abdeckung (104) über ein Gelenk (110) schwenkbar mit dem Hauptkörper (102) verbunden ist.

8. Thermostat (100) gemäß Anspruch 7, wobei der Stift (122) an dem dem Gelenk (110) gegenüberliegenden Ende der Abdeckung positioniert ist.

9. Thermostat (100) gemäß einem der vorhergehenden Ansprüche, wobei der Bedienungsknopf ein erster Bedienungsknopf (118) ist und der Thermostat einen zweiten Bedienungsknopf (108) beinhaltet, wobei der zweite Bedienungsknopf zugänglich ist, wenn sich die Abdeckung (104) in der geschlossenen Konfiguration befindet.

10. Thermostat (100) gemäß Anspruch 9, wobei ein erster Satz Funktionen durch den ersten Bedienungsknopf (118) gesteuert wird und ein zweiter Satz Funktionen des Thermostats durch den zweiten Bedienungsknopf (108) gesteuert wird.

11. Thermostat (100) gemäß Anspruch 9 oder Anspruch 10, wobei der zweite Bedienungsknopf (108) den Temperatursollwert steuert.

## Revendications

1. Un thermostat (100) comprenant un corps principal (102) et un cache (104), le corps principal comprenant un écran d'affichage (106), un bouton de commande (118), et un compartiment à batterie (126) servant à loger une batterie (128) pour alimenter en puissance le thermostat,
où le cache peut être déplacé entre une configuration ouverte dans laquelle le compartiment à batterie et le bouton de commande sont accessibles, et une configuration fermée dans laquelle le cache protège le compartiment à batterie et le bouton de commande,
**caractérisé en ce que** le thermostat comprend en outre :
un doigt (122) saillant d'un élément parmi le cache ou le corps principal ;
une fente (124) dans l'autre élément parmi le cache ou le corps principal, servant à recevoir le doigt lorsque le cache est dans la configuration fermée ;
un premier alésage (114) s'étendant à travers le cache ou le corps principal, et un deuxième alésage (123) s'étendant à travers le doigt, les premier et deuxième alésages étant alignés lorsque le cache est dans la configuration fermée ;
et un organe de fixation (132) pouvant être reçu dans le premier alésage, servant à être inséré dans le deuxième alésage lorsque le cache est dans la configuration fermée,
empêchant de ce fait un retrait du doigt de la fente de telle sorte que le cache soit verrouillé dans la configuration fermée, où le doigt, la fente, le premier alésage, le deuxième alésage et l'organe de fixation forment un agencement de verrouillage servant à verrouiller le cache dans la configuration fermée.

2. Le thermostat (100) de la revendication 1, où l'organe de fixation comprend une tête d'organe de fixation, et la tête d'organe de fixation est renfoncée au sein du premier alésage (114) lorsque le cache (104) est verrouillé dans la configuration fermée.

3. Le thermostat (100) de la revendication 1 ou de la revendication 2, où l'organe de fixation est une vis comprenant une tige filetée et une tête de vis (134).

4. Le thermostat (100) de la revendication 3, où la tête de vis (134) n'est pas sous la forme d'une tête de vis fendue, Phillips ni Pozidriv.

5. Le thermostat (100) de la revendication 3, où la tête de vis (134) est sous la forme d'une tête en étoile.

6. Le thermostat (100) de la revendication 1, comprenant en outre un obturateur pouvant être reçu dans le premier alésage (114) lorsque l'organe de fixation n'est pas reçu dans le premier alésage, obturant de ce fait l'entrée du premier alésage.

7. Le thermostat (100) de n'importe quelle revendication précédente, où le cache (104) est raccordé de manière pivotante au corps principal (102) par l'intermédiaire d'une charnière (110).

8. Le thermostat (100) selon la revendication 7, où le doigt (122) est positionné au niveau de l'extrémité opposée du cache par rapport à la charnière (110).

9. Le thermostat (100) selon n'importe quelle revendication précédente, où le bouton de commande est un premier bouton de commande (118), et le thermostat comprend un deuxième bouton de commande (108), le deuxième bouton de commande étant accessible lorsque le cache (104) est dans la configuration fermée.

10. Le thermostat (100) selon la revendication 9, où un premier ensemble de fonctions est commandé par le premier bouton de commande (118), et un deuxième ensemble de fonctions du thermostat est commandé par le deuxième bouton de commande (108).

11. Le thermostat (100) selon la revendication 9 ou la revendication 10, où le deuxième bouton de commande (108) commande le point de consigne de température.
